# EUROPEAN PATENT APPLICATION

(11) **EP 4 632 796 A1**
(43) Date of publication of application: **15.10.2025**
(21) Application number: 23900295.9
(22) Date of filing: 04.10.2023
(51) Int. Cl.: H01L 21/31, C23C 16/44, H01L 21/318

(54) **SUBSTRATE PROCESSING DEVICE, METHOD FOR MANUFACTURING SEMICONDUCTOR DEVICE, AND PROGRAM**

(30) Priority: 05.12.2022 JP 2022194510
(71) Applicant: Kokusai Electric Corporation, Tokyo 101-0045 (JP)
(72) Inventor: ITATANI, Hideharu, Toyama-shi, Toyama 939-2393 (JP)
(74) Representative: Verscht, Thomas Kurt Albert
(86) International application number: PCT/JP2023/036228
(87) International publication number: WO 2024/122171

(57) **Abstract**

Provided is a technology comprising: a plurality of substrate support tools that can support at least one substrate; a processing container into which the plurality of substrate support tools are individually carried and in which the substrate supported by the substrate support tools is processed; a storage unit that stores cumulative values of film thicknesses of the processing container and each of the substrate support tools; and a control unit configured to be able to control execution of a cleaning process on the processing container and the substrate support tools, by allocating a predefined cleaning time for the processing container for each of the substrate support tools on the basis of the cumulative values for the substrate support tools when the cumulative value for the processing container becomes equal to or larger than a predefined threshold value, and by inserting/pulling out the substrate support tools into/from the processing container in accordance with the allocated cleaning time for said each of the substrate support tools.

## Description

### [Technical Field]

The present disclosure relates to a substrate processing apparatus, a method of manufacturing a semiconductor device and a program.

### [Related Art]

As one of substrate processing apparatuses capable of processing a substrate, a substrate processing apparatus including a process vessel and a substrate retainer (also referred to as a "substrate support") capable of accommodating a plurality of substrates in a multistage manner may be used. The substrate processing apparatus is configured to perform a film forming process for the substrate while the substrate retainer is inserted into the process vessel. When the film forming process for the substrate is repeatedly performed in such a substrate processing apparatus, a film may accumulate on the process vessel and the substrate retainer. In such a case, a cleaning may be performed to remove the film (which is accumulated) from both of the process vessel and the substrate retainer.

### [Related Art Document]

### [Patent Document]

Patent Document 1: Japanese Patent Laid-Open No. 2013-214726

### [Disclosure]

### [Technical Problem]

According to the present disclosure, there is provided a technique capable of efficiently performing a cleaning of removing an accumulated film in a substrate processing apparatus when the substrate processing apparatus is configured to operate a plurality of substrate supports for one process vessel.

### [Technical Solution]

According to an embodiment of the present disclosure, there is provided a technique that includes: a substrate support configured to be capable of supporting at least one substrate; a process vessel into which a plurality of substrate supports are individually loaded so the substrate supported by the substrate support is processed therein; a memory configured to store accumulated film thickness values of the process vessel and the plurality of substrate supports; and a controller configured to be capable of controlling an execution of a cleaning process for the process vessel and the substrate support by performing: allocating a predefined cleaning time for the process vessel to the plurality of substrate supports based on the accumulated film thickness values of the plurality of substrate supports when the accumulated film thickness value of the process vessel is equal to or greater than a threshold value which is predefined, and loading and unloading each of the plurality of substrate supports into and out of the process vessel in accordance with a cleaning time allocated for each of the plurality of substrate supports.

### [Advantageous Effects]

According to some embodiments of the present disclosure, it is possible to efficiently perform a cleaning of removing an accumulated film in a substrate processing apparatus when the substrate processing apparatus is configured to operate a plurality of substrate supports for one process vessel.

### [Brief Description of Drawings]

FIG. 1 is a diagram schematically illustrating an overall perspective view of a substrate processing apparatus.
FIG. 2 is a diagram schematically illustrating a cross-section of the substrate processing apparatus when viewed from above.
FIG. 3 is a diagram schematically illustrating a vertical cross-section of a process furnace of the substrate processing apparatus.
FIG. 4 is a block diagram schematically illustrating a controller of the substrate processing apparatus.
FIG. 5 is a flow chart schematically illustrating a film thickness monitoring process.
FIG. 6 is a flow chart schematically illustrating a part of a process performed by a main controller after receiving a cleaning signal.
FIG. 7 is a flow chart schematically illustrating a cleaning time allocation process.
FIG. 8 is a table schematically illustrating a specific example of a cleaning time allocation.
FIG. 9 is a flow chart schematically illustrating a cleaning process.
FIG. 10 is a diagram schematically illustrating positions of boats in the cleaning process, wherein FIG. 10(A) is a diagram schematically illustrating a state in which a first boat is disposed in a process chamber, FIG. 10(B) is a diagram schematically illustrating a state in which a second boat is disposed in the process chamber, and FIG. 10(C) is a diagram schematically illustrating a state in which a third boat is disposed in the process chamber.

### [Detailed Description]

Hereinafter, embodiments according to the technique of the present disclosure will be described mainly with reference to the drawings. Further, the drawings used in the following descriptions are all schematic. For example, a relationship between dimensions of each component and a ratio of each component shown in the drawing may not always match the actual ones. Further, even between the drawings, the relationship between the dimensions of each component and the ratio of each component may not always match. In addition, a process temperature in the present specification may refer to a temperature of a substrate (that is, a wafer 7) or a temperature (inner temperature) of a process chamber (that is, a process chamber 101).

### <Configuration of Substrate Processing Apparatus>

A substrate processing apparatus 1 according to the present embodiments is configured to perform a process for the substrate by executing a substrate processing based on a recipe in which process procedures and process conditions are defined, and is configured as a vertical and batch type substrate processing apparatus capable of simultaneously processing a plurality of substrates.

As the substrate to be processed, for example, a semiconductor wafer substrate (hereinafter, also simply referred to as a "wafer") on which a semiconductor integrated circuit device (semiconductor device) is manufactured. In addition, as a typical example of the process performed by the substrate processing apparatus, a film forming process such as a process of forming a film on a surface of the wafer may be performed.

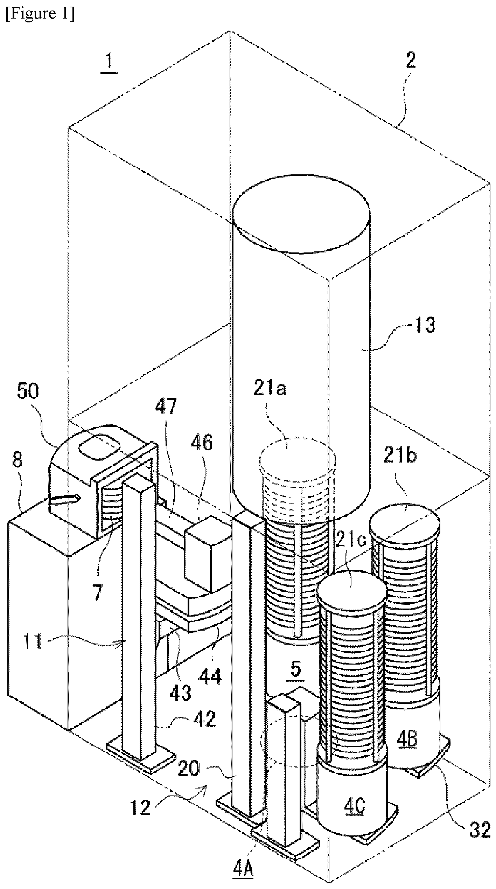

FIG. 1 is a diagram schematically illustrating an overall perspective view of the substrate processing apparatus 1 capable of performing a method of manufacturing a device. The substrate processing apparatus 1 includes a housing 2 configured as a pressure resistant container. A transfer stage 8 through which a pod 50 serving as a substrate storage container is transferred is provided in front of the housing 2 (diagonally left rear in FIG. 1).

The pod 50 is a sealed transfer container which is transferred while storing a predetermined number of wafers 7 to be processed, and includes a lid which can be opened and closed. Specifically, for example, a FOUP (front opening unified pod) is used as the pod 50.

The transfer stage 8 is configured such that the pod 50 can be transferred between the substrate processing apparatus 1 and an outside thereof, and is provided with a door opening/closing apparatus (not shown) capable of opening and closing the lid (not shown) of the pod 50. In addition, a wafer loading/unloading port (not shown) is opened in a front wall of the housing 2 corresponding to the transfer stage 8 so as to communicate between an inside and an outside of the housing 2.

Inside the housing 2, a wafer transfer structure 11, a boat transfer structure 12 and a process furnace 13 are arranged, broadly speaking. In addition, a configuration of the process furnace 13 will be described later.

### <Wafer Transfer Structure>

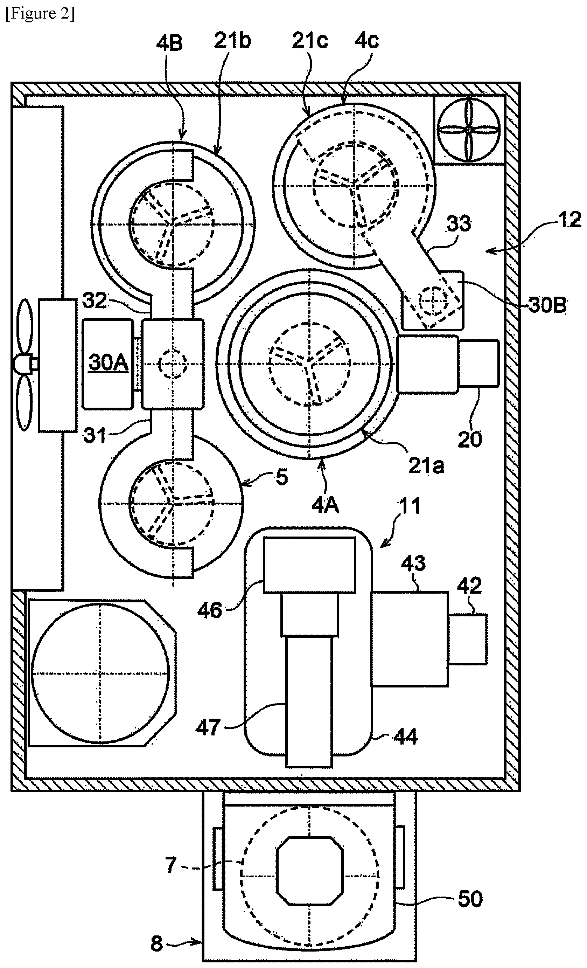

As shown in FIG. 1 or 2, the wafer transfer structure 11 is disposed opposite the transfer stage 8 across the wafer loading/unloading port, and is configured to transfer the wafers 7 between the pod 50 on the transfer stage 8 and a boat 21 serving as a substrate retainer supported by the boat transfer structure 12 described later. More specifically, the wafer transfer structure 11 includes: an elevator 42 including an elevating structure; an elevating base 43 elevated and lowered by the elevator 42; a rotating table 44 rotatably mounted on the elevating base 43; and a wafer transfer head 46 which is movable forward and backward on the rotating table 44. The wafer transfer head 46 is provided with a predetermined number of wafer transfer plates 47 capable of supporting the wafers 7. The wafer transfer plates 47 are arranged in a vertical direction. Further, the wafer transfer structure 11 is configured to be capable of loading the wafers 7 into the boat 21 and unloading the wafers 7 from the boat 21 by cooperation of an elevating operation, a lowering operation, a rotating operation and a moving forward and backward operation.

In addition, the wafer transfer structure 11 is electrically connected to a machine controller 205 in a controller 200 described later, and is configured to control operations such as the elevating operation, the lowering operation, the rotating operation and the moving forward and backward operation in accordance with an instruction from the machine controller 205.

### <Boat Transfer Structure>

As shown in FIG. 1 or 2, the boat transfer structure 12 is disposed in a rear area of the wafer transfer structure 11 (a rear side when viewed from the front of the housing 2), and is provided with four stages 4A, 4B, 4C and 5 which are configured to support the boat 21. In addition, the boat transfer structure 12 is configured to transfer the boat 21 among the stages 4A, 4B, 4C and 5.

The boat 21 is configured to accommodate (or support) a plurality of wafers 7 (for example, 50 wafers or more and 200 wafers or less) in a horizontal direction with their centers aligned in the vertical direction. In addition, the boat 21 is made of a heat resistant material such as quartz (SiO₂) and silicon carbide (SiC).

As the four stages 4A, 4B, 4C and 5, a transfer position (which is a position closest to the wafer transfer structure 11 where the wafer 7 is loaded or unloaded by the wafer transfer structure 11) (hereafter, abbreviated as "TR") stage 5, escape position (hereafter, abbreviated as "ES") stages 4B and 4C located at positions apart from the wafer transfer structure 11, and a boat load position (hereafter, abbreviated as "BL") stage 4A located among the stages 4B, 4C and 5 and directly below the process furnace 13 are provided.

In addition, the boat transfer structure 12 also includes a boat elevator 20 provided in correspondence with the BL stage 4A. The boat elevator 20 is configured to load the boat 21 from a position of the BL stage 4A into the process furnace 13 and to unload the boat 21 from the process furnace 13 to the position of the BL stage 4A.

In addition, as shown in FIG. 2, the boat transfer structure 12 includes boat transport structures 30A and 30B provided at positions facing each other across the boat elevator 20 and the BL stage 4A. The boat transport structures 30A and 30B are configured to transfer the boat 21 among the TR stage 5, the BL stage 4A and the ES stages 4B and 4C. The boat transport structure 30A is provided with an upper arm 32 and a lower arm 31. The boat transport structure 30B is provided with an arm 33. Each of the upper arm 32, the lower arm 31 and the arm 33 is of an arc shape such that the upper arm 32, the lower arm 31 and the arm 33 can be fitted into predetermined positions of the boat 21.

In addition, the boat transfer structure 12 is configured such that the boat elevator 20, the boat transport structures 30A and 30B and the like are electrically connected to the machine controller 205 in the controller 200 described later, and such that the boat 21 is controlled in accordance with an instruction from the machine controller 205 to perform the operations such as the elevating operation, the lowering operation, the rotating operation and the moving forward and backward operation.

### <Process Chamber>

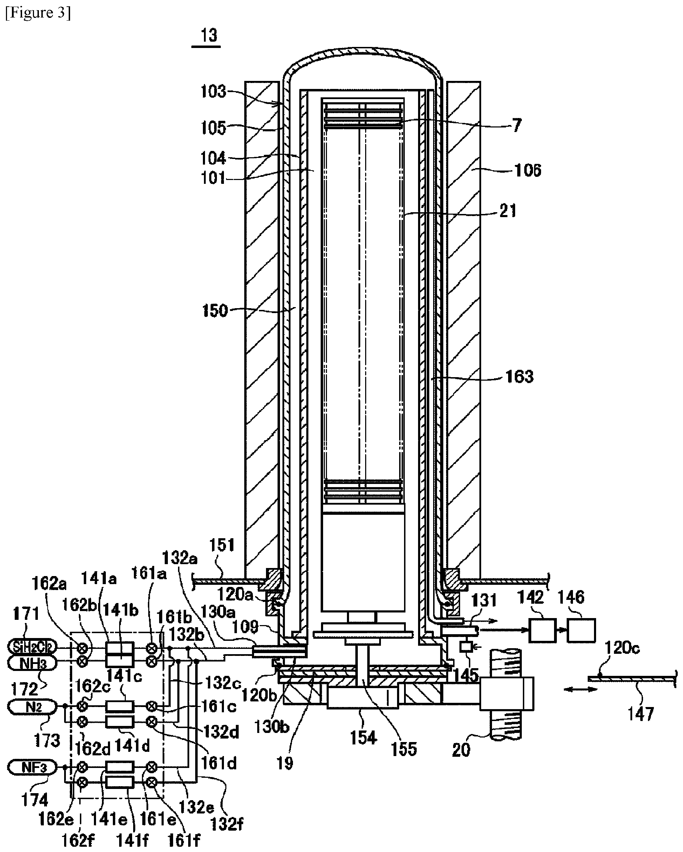

As shown in FIG. 3, the process furnace 13 includes a process tube 103. The process tube 103 includes an inner tube 104 and an outer tube 105 provided on an outer side of the inner tube 104. For example, the inner tube 104 is made of a heat resistant material such as quartz (SiO₂) and silicon carbide (SiC). The inner tube 104 is of a cylindrical shape with open upper and lower ends. The process chamber 101 in which the wafer 7 serving as the substrate is processed is formed (provided) in a hollow cylindrical portion of the inner tube 104. Thereby, the inner tube 104 is configured such that the boat 21 can be loaded into the inner tube 104 and can be accommodated. The outer tube 105 is provided in a manner concentric with the inner tube 104. The outer tube 105 is of a cylindrical shape with a closed upper end and an open lower end, and an inner diameter of the outer tube 105 is set to be greater than an outer diameter of the inner tube 104. For example, the outer tube 105 is made of a heat resistant material such as SiO₂ and SiC.

### <Heater>

A heater 106 is provided on the outside of the process tube 103 so as to surround a side wall surface of the process tube 103. The heater 106 is configured to generate a heat when an electric power is supplied to a heater wire thereof, and is installed vertically by being supported by a heater base 151. A temperature sensor 163 is provided between the inner tube 104 and the outer tube 105. The heater 106 and the temperature sensor 163 are electrically connected to a temperature controller 202 in the controller 200 described later.

### <Manifold>

A manifold 109 is arranged below the outer tube 105 in a manner concentric with the outer tube 105. For example, the manifold 109 is made of a material such as stainless steel, and is of a cylindrical shape with open upper and lower ends. The manifold 109 engages with the lower end of the inner tube 104 and the lower end of the outer tube 105, and is provided to support the inner tube 104 and the outer tube 105. In addition, an O-ring 120a serving as a seal is provided between the manifold 109 and the outer tube 105. The manifold 109 is supported by the heater base 151 such that the process tube 103 is installed vertically. A process vessel is constituted by the process tube 103 and the manifold 109.

### <First Gas Supplier>

A nozzle 130a is provided in the manifold 109 so as to communicate with the process chamber 101. A silicon-containing gas serving as a first gas is supplied into the process chamber 101 through the nozzle 130a. A downstream end of a gas supply pipe 132a is connected to an upstream end of the nozzle 130a. A first gas supply source 171, a valve 162a, a mass flow controller (MFC) 141a and a valve 161a are sequentially installed at the gas supply pipe 132a in this order from an upstream side to a downstream side of the gas supply pipe 132a. A first gas supplier is constituted mainly by the nozzle 130a, the gas supply pipe 132a, the MFC 141a, and the valves 161a and 162a. The first gas supplier may further include the first gas supply source 171. The MFC 141a and the valves 161a and 162a are electrically connected to a gas flow rate controller 204 in the controller 200 be described later.

### <Second Gas Supplier>

A nozzle 130b is provided in the manifold 109 so as to communicate with the process chamber 101. A nitrogen-containing gas serving as a second gas is supplied into the process chamber 101 through the nozzle 130b. A downstream end of a gas supply pipe 132b is connected to an upstream end of the nozzle 130b. A second gas supply source 172, a valve 162b, an MFC 141b, and a valve 161b are sequentially installed at the gas supply pipe 132b in this order from an upstream side to a downstream side of the gas supply pipe 132b. A second gas supplier is constituted mainly by the nozzle 130b, the gas supply pipe 132b, the MFC 141b, and the valves 161b and 162b. The second gas supplier may further include the second gas supply source 172. The MFC 141b and the valves 161b and 162b are electrically connected to the gas flow rate controller 204 in the controller 200 be described later.

### <Third Gas (Cleaning Gas) Supplier>

A gas supply pipe 132e is connected to the gas supply pipe 132a at a downstream side of the valve 161a of the gas supply pipe 132a. For example, a fluorine (F)-containing gas serving as a cleaning gas (third gas) is supplied into the process chamber 101 through the gas supply pipe 132e. For example, as the fluorine-containing gas, a gas such as chlorine trifluoride (ClF₃) gas, chlorine fluoride (ClF) gas, nitrogen trifluoride (NF₃) gas, hydrogen fluoride (HF) gas and fluorine (F₂) gas may be used. One or more of the gases exemplified above may be used as the fluorine-containing gas. A third gas supply source 174, a valve 162e, an MFC 141e, and a valve 161e are sequentially installed at the gas supply pipe 132e in this order from an upstream side to a downstream side of the gas supply pipe 132e.

In addition, a gas supply pipe 132f is connected to the gas supply pipe 132b at a downstream side of the valve 161b of the gas supply pipe 132b. The third gas is supplied into the process chamber 101 through the gas supply pipe 132f. An upstream end of the gas supply pipe 132f is connected to an upstream side of the valve 162e of the gas supply pipe 132e. A valve 162f, an MFC 141f and a valve 161f are sequentially installed at the gas supply pipe 132f in this order from an upstream side to a downstream side of the gas supply pipe 132f.

A third gas supplier is constituted mainly by the nozzles 130a and 130b, the gas supply pipes 132a, 132b, 132e and 132f, the MFCs 141e and 242f and the valves 161e, 161f, 162e and 162f. The third gas supplier may further include the third gas supply source 174.

The MFCs 141e and 242f and the valves 161e, 161f, 162e and 162f are electrically connected to the gas flow rate controller 204 in the controller 200 be described later.

### <Fourth Gas (Inert Gas) Supplier>

A gas supply pipe 132c is connected to the gas supply pipe 132a at the downstream side of the valve 161a of the gas supply pipe 132a. For example, a nitrogen (N₂) gas serving as an inert gas (fourth gas) is supplied into the process chamber 101 through the gas supply pipe 132c. A fourth gas supply source 173, a valve 162c, an MFC 141c and a valve 161c are sequentially installed at the gas supply pipe 132c in this order from an upstream side to a downstream side of the gas supply pipe 132c.

In addition, a gas supply pipe 132d is connected to the gas supply pipe 132b at the downstream side of the valve 161b of the gas supply pipe 132b. An upstream end of the gas supply pipe 132d is connected to an upstream side of the valve 162c of the gas supply pipe 132c. A valve 162d, an MFC 141d, and a valve 161dare sequentially installed at the gas supply pipe 132d in this order from an upstream side to a downstream side of the gas supply pipe 132d.

A fourth gas supplier is constituted mainly by the nozzles 130a and 130b, the gas supply pipes 132a, 132b, 132c and 132d, the MFCs 141c and 141d and the valves 161c, 161d, 162c and 162d. The fourth gas supplier may further include the fourth gas supply source 173.

The MFCs 141c and 141d and the valves 161c, 161d, 162c and 162d are electrically connected to the gas flow rate controller 204 in the controller 200 described later. A gas supplier of the present disclosure is constituted mainly by at least one among the first gas supplier, the second gas supplier, the third gas supplier and the fourth gas supplier.

### <Exhauster>

The manifold 109 is provided with an exhaust pipe 131 through which an atmosphere (inner atmosphere) of the process chamber 101 is exhausted. The exhaust pipe 131 is disposed at a lower end portion of a cylindrical space 150 formed by a gap between the inner tube 104 and the outer tube 105, and is connected to the cylindrical space 150. A vacuum exhaust apparatus 146 such as a vacuum pump is provided at a downstream side of the exhaust pipe 131 (opposite to a side connected to the manifold 109) via a pressure sensor 145 and a pressure regulator (pressure adjusting structure) 142 such as a variable conductance valve. For example, as the variable conductance valve, an APC (Automatic Pressure Controller) valve and the like may be used. The vacuum exhaust apparatus 146 is configured to exhaust the inner atmosphere of the process chamber 101 such that a pressure (inner pressure) of the process chamber 101 can be set to a predetermined pressure (vacuum level). The pressure regulator 142 and the pressure sensor 145 are electrically connected to a pressure controller 203 in the controller 200 described later.

With such a configuration described above, each of the first gas, the second gas, the third gas and the fourth gas flows upward inside the inner tube 104 (inside the process chamber 101), flows out through an upper end opening of the inner tube 104 into the cylindrical space 150, flows downward in the cylindrical space 150, and then is exhausted through the exhaust pipe 131. An exhauster according to the present embodiments is constituted mainly by the exhaust pipe 131 and the pressure regulator 142. The exhauster may further include the vacuum exhaust apparatus 146.

### <Seal Cap>

A lower portion of the manifold 109 is airtightly closed by a seal cap 19 provided on the boat elevator 20 of the boat transfer structure 12. In other words, the seal cap 19 functions as a furnace opening lid capable of airtightly closing a lower end opening of the manifold 109, and is configured to abut against the lower end of the manifold 109 from thereunder in the vertical direction. For example, the seal cap 19 is of a disk shape, and is made of a metal material such as stainless steel. An O-ring 120b serving as a seal is provided on an upper surface of the seal cap 19 to abut against the lower end of the manifold 109.

### <Rotator>

A rotator 154 configured to the boat 21 is installed in the vicinity of a center of the seal cap 19 and opposite to the process chamber 101. A rotating shaft 155 of the rotator 154 passes through the seal cap 19 so as to support the boat 21 from thereunder. The rotator 154 is configured to be capable of rotating the boat 21.

### <Boat Elevator>

The seal cap 19 is configured to be elevated and lowered vertically by the boat elevator 20 installed vertically outside the process tube 103. By elevating and lowering the seal cap 19, the boat 21 can be transferred into and out of the process chamber 101. The rotator 154 and the boat elevator 20 are electrically connected to the machine controller 205 in the controller 200 described later.

### <Shutter>

In addition, a furnace opening shutter 147 serving as a second furnace opening lid is provided below the manifold 109. The furnace opening shutter 147 is capable of airtightly closing the lower end opening of the manifold 109. The furnace opening shutter 147 is configured to abut against the lower end of the manifold 109 after the boat 21 is unloaded out of the process chamber 101 by the elevating operation, the lowering operation and the rotating operation, and to airtightly close an inside of the process chamber 101 after the boat 21 is unloaded. An O-ring 120c serving as a seal is provided on an upper surface of the furnace opening shutter 147 to abut against the lower end of the manifold 109.

### (3) Configuration of Controller

A processing operation of the substrate processing apparatus 1 configured as described above is controlled by instructions from the controller 200 serving as a control structure. The controller 200 may be installed in the housing 2 of the substrate processing apparatus 1, or may be installed separately from the housing 2 of the substrate processing apparatus 1 and electrically connected via a communication line and the like.

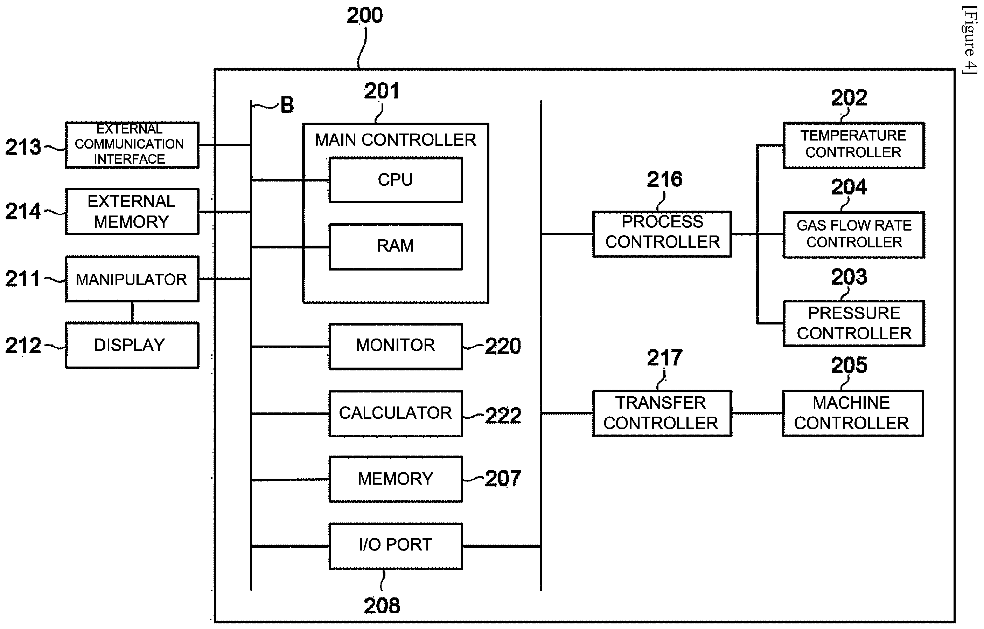

A configuration of the controller 200 according to the present embodiments will be described below with reference to the drawings. As shown in FIG. 4, the controller 200 is configured with a main controller 201 and a plurality of controllers, which are implemented by a computer. The computer in the present specification is configured to execute a program to perform information processing instructed by the program, and is specifically implemented by a combination of a CPU (Central Processing Unit), a RAM (Random Access Memory), a memory, an input/output device and the like. As the plurality of controllers, the temperature controller 202, the pressure controller 203, the gas flow rate controller 204 and the machine controller 205 are provided. The temperature controller 202, the pressure controller 203 and the gas flow rate controller 204 are connected to a process controller 216, and the machine controller 205 is connected to a transfer controller 217. The process controller 216 and the transfer controller 217 are connected to an I/O port (input/output port) 208 via a communication line, and are connected to the main controller 201 via a bus B.

The temperature controller 202 is configured to control a state of electric conduction to the heater 106 at a desired timing based on temperature information detected by the temperature sensor 163 such that a desired temperature distribution of the inner temperature of the process chamber 101 can be obtained.

The pressure controller 203 is configured to control the pressure regulator 142 at a desired timing based on pressure information detected by the pressure sensor 145 such that the inner pressure of the process chamber 101 can be set to a desired pressure.

The gas flow rate controller 204 is configured to control a flow rate of a gas supplied into the process chamber 101. More specifically, the gas flow rate controller 204 is configured to control the MFC 141a and the valves 161a and 162a such that a flow rate of the silicon-containing gas supplied into the process chamber 101 can be set to a predetermined flow rate at a predetermined timing. In addition, the gas flow rate controller 204 is configured to control the MFC 141b and the valves 161b and 162b such that a flow rate of the nitrogen-containing gas supplied into the process chamber 101 can be set to a predetermined flow rate at a predetermined timing. In addition, the gas flow rate controller 204 is configured to control the MFCs 141e and 141f and the valves 161e, 161f, 162e and 162f such that a flow rate of the cleaning gas supplied into the process chamber 101 can be set to a predetermined flow rate at a predetermined timing. In addition, the gas flow rate controller 204 is configured to control the MFCs 141c and 141d and the valves 161c, 161d, 162c and 162d such that a flow rate of the inert gas supplied into the process chamber 101 can be set to a predetermined flow rate at a predetermined timing.

The machine controller 205 is configured to control the wafer transfer structure 11, the boat transport structure 30, the boat elevator 20, the rotator 154 and the like such that they perform desired operations at a desired timing.

The main controller 201 is configured to control the temperature controller 202, the pressure controller 203 and the gas flow controller 204 via the process controller 216, and to control the machine controller 205 via the transfer controller 217, thereby controlling an overall operation of the substrate processing apparatus 1.

In addition to the controllers described above, the main controller 201 is connected to a manipulator 211 (for example, constituted by a touch panel and the like), a display 212 such as a display, an external communication interface 213 for communicating with an external apparatus, and an external memory 214 (which is a memory provided externally).

The controller 200 is provided with a memory 207. The memory 207 includes a storage such as a hard disk device, and is configured to store various programs and recipes for operating the substrate processing apparatus 1. In addition, the recipes stored in the memory 207 may include a maintenance recipe for cleaning the inside of the process chamber 101, in addition to a recipe in which the process procedures and the process conditions of the substrate processing are defined. For example, as the maintenance recipe, a gas cleaning recipe or a purge cleaning recipe is stored in the memory 207. The memory 207 is connected to the main controller 201 via the bus B.

The controller 200 includes a monitor 220 and a calculator 222. Each of the monitor 220 and the calculator 222 is implemented by a computer, and is configured to execute a program to perform information processing instructed by the program. As described later, the monitor 220 is provided with a function of monitoring an accumulated film thickness A0 in the process chamber 101, and executes a film thickness monitoring process. As described later, the calculator 222 is provided with a function of allocating a cleaning time with respect to the boats 21 (a first boat 21a, a second boat 21b and a third boat 21c) in accordance with an accumulated film thickness of the boat 21 (that is, the first boat 21a, the second boat 21b and the third boat 21c), and executes a cleaning time allocation process to allocate the cleaning time.

The controller 200 may be embodied by installing the above-mentioned program stored in the external memory 124 in the computer. For example, the external memory 124 may include a magnetic disk such as a hard disk drive (HDD), an optical disk such as a CD, a magneto-optical disk such as an MO and a semiconductor memory such as a USB memory and a solid state drive (SSD). The memory 207 or the external memory 124 may be embodied by a non-transitory computer readable recording medium. Hereafter, the memory 207 and the external memory 124 may be collectively or individually referred to as a "recording medium". Thus, in the present specification, the term "recording medium" may refer to the memory 207 alone, may refer to the external memory 124 alone, or may refer to both of the memory 207 and the external memory 124. Instead of the external memory 124, a communication structure such as the Internet and a dedicated line may be used for providing the program to the computer.

### (4) Substrate Processing Method

Subsequently, a substrate processing method performed using the substrate processing apparatus 1 will be described. Hereafter, the substrate processing method will be described by way of an example in which the substrate processing serving as a part of a manufacturing process of a semiconductor device is performed. In addition, when performing the substrate processing, the substrate processing apparatus 1 includes three boats 21 (hereinafter, the three boats 21 will be referred to and identified as the "first boat 21a", the "second boat 21b", and the "third boat 21c", respectively) as shown in FIG. 1, and the three boats 21 are placed on the TR stage 5 and the ES stages 4B and 4C, respectively.

When performing the substrate processing, the controller 200 first reads out a recipe corresponding to the substrate processing to be performed from the memory 207, and loads the recipe read from the memory 207 into the RAM in the main controller 201. Then, the main controller 201 issues operation instructions to each of the controllers 202, 203, 204 and 205 via the process controller 216 and the transfer controller 217. The substrate processing thus performed can be broadly divided into a transfer step, a loading step, a film forming step, a boat transfer step and an unloading step.

### <Transfer Step>

When the first boat 21a placed on the TR stage 5 is an empty boat, the main controller 201 issues an instruction to the machine controller 205 to drive the wafer transfer structure 11. Then, following the instruction from the machine controller 205, the wafer transfer structure 11 starts a transfer process of transferring the wafer 7 from the pod 50 on the transfer stage 8 to the first boat 21a on the TR stage 5. The transfer process is performed until the entirety of the wafers 7 to be processed are loaded into the boat 21.

### <Loading Step>

When a predetermined number of wafers 7 are loaded into the first boat 21a on the TR stage 5, the first boat 21a is transferred from the TR stage 5 to the BL stage 4A by the lower arm 31 (which operates in accordance with an instruction from the machine controller 205) of the boat transport structure 30, and then placed on the seal cap 19 of the boat elevator 20. After the first boat 21a is transferred, the lower arm 31 returns to the TR stage 5.

Then, the first boat 21a is elevated by the boat elevator 20 (which operates in accordance with an instruction from the machine controller 205), and loaded into the process chamber 101 formed in the inner tube 104 of the process furnace 13. When the first boat 21a is completely loaded, the seal cap 19 of the boat elevator 20 airtightly closes the lower end of the manifold 109 of the process furnace 13.

At this time, the inside of the process chamber 101 is purged by supplying the N₂ gas in accordance with an instruction from the gas flow rate controller 204. That is, after a flow rate of the N₂ gas (which is supplied from the fourth gas supply source 173 into the gas supply pipes 132c and 132d by opening the valves 162c, 161c, 162d and 161d) is controlled to a predetermined flow rate by the MFCs 141c and 141d, the N₂ gas whose flow rate is controlled is supplied into the process chamber 101 through the nozzles 130a and 130b via the gas supply pipes 132a and 132b. In addition, the N₂ gas is continuously supplied into the process chamber 101 until an entirety of the step of the substrate processing are completed.

### <Film Forming Step>

Then, the inside of the process chamber 101 is vacuum-exhausted by the vacuum exhaust apparatus 146 to a predetermined film forming pressure in accordance with an instruction from the pressure controller 203. In addition, the inside of the process chamber 101 is heated by the heater 106 to a predetermined temperature in accordance with an instruction from the temperature controller 202. Then, the rotator 154 starts rotating the first boat 21a in accordance with an instruction from the machine controller 205.

When the inside of the process chamber 101 is maintained at the predetermined film forming temperature and the predetermined film forming pressure, for example, a supply of the silicon-containing gas and a supply of the nitrogen-containing gas into the process chamber 101 are started in accordance with an instruction from the gas flow rate controller 204. That is, the first gas supplied from the first gas supply source 171 into the gas supply pipe 132a by opening the valves 162a and 161a is controlled to a predetermined flow rate by the MFC 141a. The first gas whose flow rate is controlled then passes through the gas supply pipe 132a, and is supplied into the process chamber 101 through the nozzle 130a. In addition, the second gas supplied from the second gas supply source 172 into the gas supply pipe 132b by opening the valves 162b and 161b is controlled to a predetermined flow rate by the MFC 141b. The second gas whose flow rate is controlled then passes through the gas supply pipe 132b, and is supplied through the nozzle 130b into the process chamber 101.

At this time, the N₂ gas supplied into the process chamber 101 functions as a dilution gas for diluting a film forming gas (that is, the first gas and the second gas) or as a carrier gas for promoting a diffusion of the film forming gas into the process chamber 101. By controlling a supply flow rate of the N₂ gas, it is possible to control a concentration and a diffusion rate of the film forming gas.

The film forming gas comes into contact with the surface of the wafer 7 as the film forming gas passes through the process chamber 101. At this time, a thin film (hereinafter, also simply referred to as a "film") is deposited on the wafer 7 by a thermal CVD (chemical vapor deposition) reaction. When a preset process time has elapsed and the film of a predetermined thickness is formed, the valves 162a, 161a, 162b and 161b are closed to stop a supply of the film forming gas into the process chamber 101. In the present specification, the process time refers to a time (time duration) during which a process related thereto is continued. The same also applies to the following descriptions. Here, when the silicon-containing gas is used as the first gas and the nitrogen-containing gas is used as the second gas, a silicon nitride film is formed on the wafer 7.

Then, the inside of the process chamber 101 is purged by exhausting the inside of the process chamber 101 while continuously supplying the N₂ gas into the process chamber 101 with the valves 162c, 161c, 162d and 161d open. When the inner atmosphere of the process chamber 101 has been replaced with the N₂ gas, by adjusting an opening degree of the pressure regulator 142, the inner pressure of the process chamber 101 is returned to a normal pressure. In addition, the electric conduction to the heater 106 is stopped to lower the inner temperature of the process chamber 101 to a predetermined temperature (wafer unloading temperature).

### <Boat Transfer Step>

During the film forming step for the first boat 21a, in accordance with an instruction from the machine controller 205, the second boat 21b or the third boat 21c is transferred from the ES stage 4B or 4C to the TR stage 5 by the boat transport structure 30.

At this time, when the second boat 21b or the third boat 21c transferred to the TR stage 5 is an empty boat, the transfer step is performed for the second boat 21b or the third boat 21c. That is, the wafers 7 in the pod 50 on the transfer stage 8 are transferred to the second boat 21b or the third boat 21c on the TR stage 5 by the wafer transfer structure 11. However, when the second boat 21b or the third boat 21c accommodates the wafers 7 (which are processed), the processed wafers 7 are removed from the second boat 21b or the third boat 21c and transferred to the pod 50, and then the wafers 7 (which are unprocessed) are transferred to the second boat 21b or the third boat 21c.

### <Unloading Step>

When the film forming step for the first boat 21a is completed, in accordance with an instruction from the machine controller 205, the rotator 154 stops rotating the first boat 21a, the seal cap 19 is lowered by the boat elevator 20 to open the lower end of the manifold 109, and the first boat 21a accommodating the processed wafers 7 is unloaded out of the process tube 103.

Then, the first boat 21a accommodating the processed wafers 7 is immediately transferred from the BL stage 4 to the ES stage 4B or ES stage 4C by the boat transport structure 30 in accordance with an instruction from the machine controller 205. After such a transfer, the first boat 21a (which is in a high temperature state and placed on the ES stage 4B or 4C) is cooled extremely effectively by clean air 15 ejected through a clean air supply structure 3. Then, when first boat 21a is cooled to, for example, 150°C or less, the first boat 21a is transferred from the ES stage 4B or 4C to above the TR stage 5 by the boat transport structure 30. At this time, the transfer of the unprocessed wafers 7 to the second boat 21b or the third boat 21c on the TR stage 5 has already been completed, and a loading of the second boat 21b or the third boat 21c into the process chamber 101 has also been completed.

By repeatedly performing each of the steps mentioned above, the substrate processing apparatus 1 of the present embodiments can form the film on the wafer 7 with a high throughput.

### (5) Maintenance Method of Substrate Processing Apparatus

The film is formed on the wafer 7 by performing the film forming step mentioned above. However, in reality, the film is also formed on surfaces other than the surface of the wafer 7, for example, surface such as such as an inner wall of the inner tube 104 and the boat 21. When the film is deposited thickly, a stress applied thereto increases. Thereby, a crack may be generated and foreign matters (particles) may be generated due to the crack in the process chamber 101. Thus, according to the present embodiments, when a thickness of the film deposited in the process tube 103 reaches a predetermined thickness by repeatedly performing the film forming step mentioned above, the substrate processing apparatus 1 performs a cleaning step as described below as a maintenance step of maintaining the process tube 103 and the like.

When performing the cleaning step, the controller 200 first reads out the maintenance recipe for a cleaning to be performed from the memory 207, and loads the maintenance recipe read from the memory 207 into the RAM in the main controller 201. Then, the main controller 201 issues operation instructions to each of the controllers 202, 203, 204 and 205, and the cleaning step is performed.

### <Cleaning (CLN) Step>

An accumulated thickness value of deposits (accumulated film) adhering to the process tube 103 (that is, the accumulated film thickness A0) (hereinafter, also simply referred to as a "film thickness A0"), an accumulated thickness value of the deposits adhering to the first boat 21a (an accumulated film thickness A1)(hereinafter, also simply referred to as a "film thickness A1"), an accumulated thickness value of the deposits adhering to the second boat 21b (an accumulated film thickness A2) (hereinafter, also simply referred to as a "film thickness A2") and an accumulated thickness value of the deposits adhering to the third boat 21c (an accumulated film thickness A3)(hereinafter, also simply referred to as a "film thickness A3") are stored in the memory 207. The accumulated thickness values mentioned above can be obtained based on a film thickness estimation value inferred from the number of times the process chamber 101 has been used in the film forming step, the duration of such a use and the like. In addition, the accumulated thickness values may be film thickness values detected by a film thickness detector (not shown) provided in the process chamber 101.

The memory 207 stores an accumulated film thickness threshold value THA (hereinafter, also simply referred to as a "threshold value THA"). The threshold value THA is a thickness of the film before peeling, falling or cracking occurs due to the stress applied in a normal process, and is defined in advance by a user. The user can set such a definition by inputting it through the manipulator 211. In addition, the memory 207 also stores a CLN time T0 corresponding to the film thickness A0. The CLN time T0 is set in advance, taking into account a CLN time corresponding to the film thickness A0. In addition, the threshold value THA may be obtained from another apparatus connected via a network by the external communication interface 213.

A storage process (storage step) of storing the film thicknesses A0 to A4 in the memory 207 is performed each time the substrate processing in the process chamber 101 is completed. The storage step is performed by adding the film thickness A0 in the process tube 103 and the accumulated film thickness of the boat which was the subject of the substrate processing (that is, the first boat 21a, the second boat 21b and/or the third boat 21c processed in the process chamber 101) to the film thickness of the deposits adhered during the substrate processing. In addition, after a CLN process described below is performed, the film thickness A0 in the process tube 103 and a film thickness A related to the boat 21 on which the CLN process has been performed are cleared to zero.

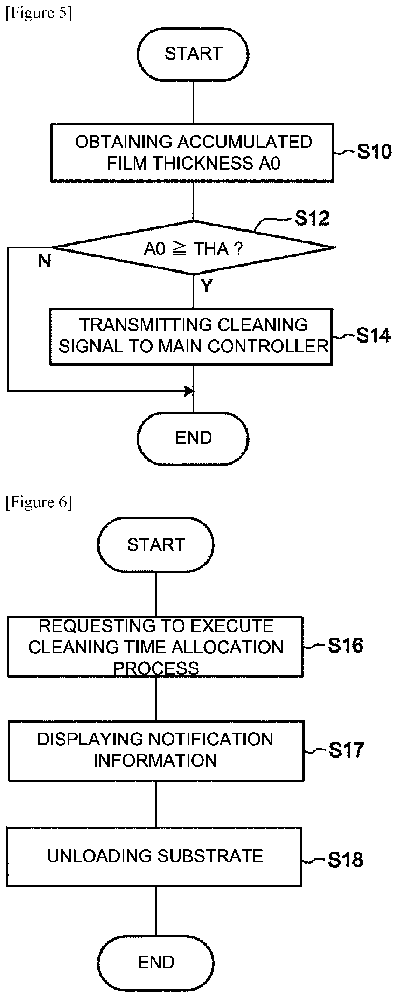

The monitor 220 is provided with a function of monitoring the film thickness A0. Specifically, the film thickness monitoring process is performed each time the accumulated film thickness storage process described above is performed. In the film thickness monitoring process, as shown in FIG. 5, the film thickness A0 in the process chamber 101 is obtained from the memory 207 (step S10), and the film thickness A0 obtained from the memory 207 is compared with the threshold value THA (step S12). When a comparison result indicates that the film thickness A0 obtained from the memory 207 is equal to or greater than the threshold value THA, a CLN signal is transmitted to the main controller 201 in a step S14, which is notification information that it is time to perform the CLN. When the comparison result indicates that the film thickness A0 obtained from the memory 207 is less than the threshold value THA, the process is terminated.

When the main controller 201 receives the CLN signal indicating that the film thickness A0 is equal to or greater than the threshold value THA, the main controller 201 determines that the CLN process should be started, and requests the calculator 222 to execute the CLN time allocation process as shown in FIG. 6 (step S16). In addition, the notification information is stored in the memory 207. Further, as the notification information, the display 212 displays a message indicating that the time to perform the CLN has arrived and that the CLN process will be executed (step S17). In addition, a display on the display 212 may be an alarm such as a lighted symbol, or a voice notification.

In addition, when the main controller 201 receives a signal indicating that the film thickness A0 is equal to or greater than the threshold value THA, when there is the wafer 7 placed on the boat 21, the main controller 201 executes an unloading process of unloading the wafer 7 (step S18). When the wafer 7 is placed on the first boat 21a, the unloading process is performed before the CLN process described later is performed, or before a step S51 in the CLN process (before the first boat 21a is loaded into the process chamber 101 and while the temperature of the process chamber 101 is being switched to a CLN temperature). When the wafer 7 is placed on the second boat 21b, the unloading process can be performed during the CLN of the first boat 21a in a step S52, and when the wafer 7 is placed on the third boat 21c, the unloading process can be performed during the CLN of the second boat 21b in a step S55.

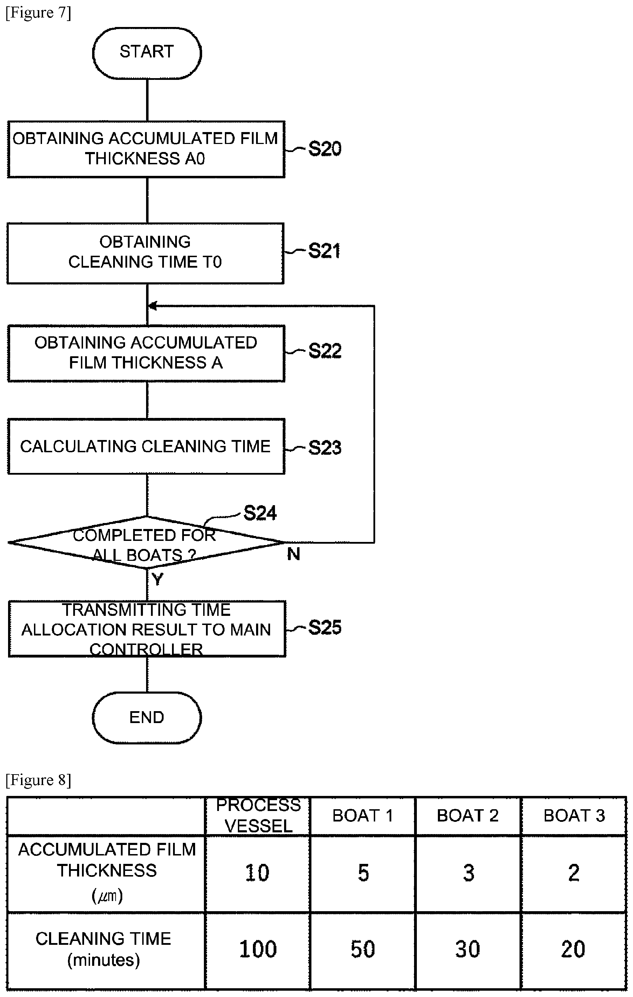

When the calculator 222 receives a request from the main controller 201, the calculator 222 executes the CLN time allocation process. Specifically, as shown in FIG. 7, in a step S20, the film thickness A0 in the process chamber 101 is obtained from the memory 207, and in a step S21, the CLN time T0 corresponding to the film thickness A0 is obtained from the memory 207. Subsequently, in a step S22, the accumulated film thickness A (A1, A2 or A3; hereafter, also simply referred to as a "film thickness A") related to the boat 21 is obtained from the memory 207. Then, in a step S23, the CLN time (T1, T2 or T3) related to that boat is calculated. The CLN time is calculated by allocating the CLN time T0 (which corresponds to the film thickness A0 obtained from the memory 207) to a time according to the film thickness A of the boat 21. Specifically, the CLN time T0 is multiplied by a value obtained by dividing the film thickness A by the film thickness A0 to calculate a time proportional to the film thickness A of the boat 21.

In a step S24, it is determined whether a calculation of the CLN time has been completed for an entirety of the boats 21. When there is the boat 21 for which the calculation of the CLN time has not been completed, the process returns to the step S22 and the steps S23 and S24 mentioned above are repeatedly performed. When the calculation of the CLN time has been completed for the entirety of the boats 21, in a step S25, an allocation result is transmitted to the main controller 201, and the CLN time allocation process is terminated.

FIG. 8 is a table schematically illustrating a specific example of a CLN time allocation. The threshold value THA is set to 10 µm. In such a case, for example, the film thickness A0 of the process tube 103 (process vessel) is set to 10 µm, the film thickness A1 of the first boat 21a is set to 5 µm, the film thickness A2 of the second boat 21b is set to 3 µm, and the film thickness A3 of the third boat 21c is set to 2 µm, which are stored in the memory 207. Since the first boat 21a, the second boat 21b and the third boat 21c are used as the boats 21 for processing using the process chamber 101, the film thickness A0 of the process tube 103 is a sum of the film thicknesses of these boats 21. The CLN time T0 of the process tube 103 is set to allocated to the boats 21 in proportion to the film thickness. The CLN time T0 of the process tube 103 is 100 minutes (which is preset) because the film thickness A0 is 10 µm. Therefore, the CLN time T1 of the first boat 21a is set to 50 minutes, the CLN time T2 of the second boat 21b is set to 30 minutes, and the CLN time T3 of the third boat 21c is set to 20 minutes. In other words, the CLN time T0 is equal to the CLN time obtained by summing the CLN time T1, the CLN time T2 and the CLN time T3.

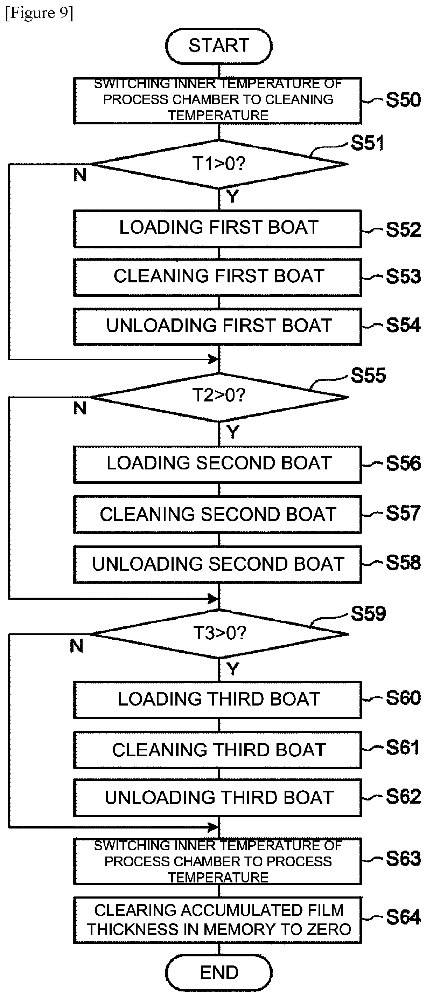

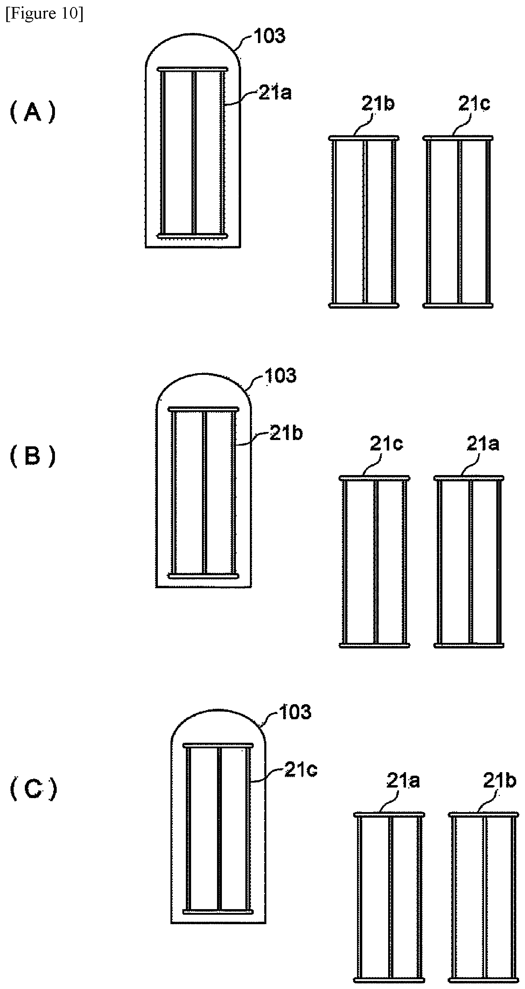

When the main controller 201 receives the allocation result from the calculator 222, the main controller 201 executes the CLN process. As shown in FIG. 9, in the CLN process, in a step S50, the inner temperature of the process chamber 101 is switched to the CLN temperature. In the step S51, it is determined whether the CLN time T1 related to the first boat 21a is greater than zero. When such a determination is affirmative, in the step S52, the first boat 21a is loaded into the process chamber 101, and in a step S53, the CLN of the first boat 21a is performed (see FIG. 10).

When the determination in the step S51 is negative, the CLN time T1 allocated to the first boat 21a is zero, and the film thickness A1 is zero. Thus, no processing is performed in the process chamber 101. Therefore, the steps S52 to S54 are skipped.

In the CLN in the step S53, a preset recipe for the CLN such as a gas cleaning a purge cleaning and the like is executed. Such a recipe is executed with the first boat 21a loaded into the process tube 103, as shown in FIG. 10(A).

For example, in the gas cleaning, the CLN gas is supplied into the process chamber 101. After the flow rate of the third gas (which is supplied from the third gas supply source 174 into the gas supply pipes 132e and 132f by opening the valves 162e, 161e, 162f and 161f) is controlled to a predetermined flow rate by the MFCs 141e and 141f, the third gas whose flow rate is controlled is supplied into the process chamber 101 through the nozzles 130a and 130b via the gas supply pipes 132a and 132b.

At this time, the N2 gas supplied into the process chamber 101 functions as a dilution gas for diluting the fluorine-containing gas (which is the CLN gas) or as a carrier gas for promoting a diffusion of the fluorine-containing gas into the process chamber 101. By controlling a supply flow rate of the N₂ gas, it is possible to control a concentration and a diffusion rate of the fluorine-containing gas.

The fluorine-containing gas comes into contact with the film and the like accumulated in the process chamber 101 and the first boat 21a as the fluorine-containing gas passes through the process chamber 101, and removes the film and the like by a thermochemical reaction. In other words, the fluorine-containing gas (which is heated and activated) becomes an etching species, and etches and removes the film and the like accumulated in the process chamber 101 and the first boat 21a.

When the CLN time T1 allocated to the first boat 21a has elapsed, the valves 162c, 161c, 162d and 161d are closed to stop the supply of the fluorine-containing gas into the process chamber 101. Then, the inside of the process chamber 101 is purged by exhausting the inside of the process chamber 101 while continuously supplying the N₂ gas into the process chamber 101 with the valves 162c, 161c, 162d and 161d open. Then, in the step S54, the first boat 21a is unloaded from the process chamber 101.

Subsequently, in the step S55, it is determined whether the CLN time T2 related to the second boat 21b is greater than zero. When such a determination is affirmative, in a step S56, the second boat 21b is loaded into the process chamber 101, and in a step S57, the CLN of the second boat 21b is performed (see FIG. 10(B)). The CLN of the second boat 21b is performed in the same manner as the first boat 21a, wherein the CLN time is set to the CLN time T2 allocated to the second boat 21b. Then, in a step S58, the second boat 21b is unloaded from the process chamber 101.

When the determination in the step S55 is negative, the CLN time T2 allocated to the second boat 21b is zero, and the film thickness A2 is zero. Thus, no processing is performed in the process chamber 101. Therefore, the steps S56 to S58 are skipped.

Subsequently, in a step S59, it is determined whether the CLN time T3 related to the third boat 21c is greater than zero. When such a determination is affirmative, in a step S60, the third boat 21c is loaded into the process chamber 101, and in a step S61, the CLN of the third boat 21c is performed (see FIG. 10(C)). The CLN of the third boat 21c is performed in the same manner as the first boat 21a, wherein the CLN time is set to the CLN time T3 allocated to the third boat 21c. Then, in a step S62, the third boat 21c is unloaded from the process chamber 101.

When the determination in the step S59 is negative, the CLN time T3 allocated to the third boat 21c is zero, and the film thickness A3 is zero. Thus, no processing is performed in the process chamber 101. Therefore, the steps S60 to S62 are skipped.

Then, in a step S63, the inner temperature of the process chamber 101 is switched to the process temperature. In a step S64, the film thickness A0 in the process chamber 101 and the film thickness A related to the boat 21 on which the CLN process was performed, which are stored in the memory 207, are cleared to zero, and the CLN process is terminated.

### <Effects According to Present Embodiments>

According to the present embodiments, it is possible to obtain one or more of the following effects.
(a) According to the present embodiments, the CLN process is performed for the plurality of boats 21 (that is, the first boat 21a, the second boat 21b and the third boat 21c) at the same timing as the CLN of the process tube 103. Therefore, it is possible to reduce the CLN process time (which includes a time for adjusting the inner temperature and the inner atmosphere of the process chamber 101) as compared with a case where the CLN of the process tube 103 and the CLN of each of the boats 21 are performed separately.
(b) According to the present embodiments, the CLN time T0 of the process tube 103 is allocated to each of the boats 21 based on the film thickness A, and each of the boats 21 is loaded into and unloaded out of the process chamber 101 in accordance with the CLN time allocated in a manner described above to perform the CLN process. Therefore, it is possible to uniformize a thickness of each film remained after each CLN process is performed. In addition, by allocating the CLN time T0 in proportion to the film thickness A, it is possible to set the CLN time in accordance with the film thickness A.
(c) According to the present embodiments, the threshold value THA is stored in the memory 207, and the film thicknesses A0, A1, A2 and A3 are updated and stored for each substrate processing. Thereby, it is possible to maintain information on the film thickness even when the substrate processing apparatus 1 is restarted. In addition, after the CLN process is completed, the accumulated film thicknesses stored in the memory 207 are cleared to zero. Thereby, it is possible to maintain the latest accumulated film thicknesses. The same also applies to the notification information.
(d) According to the present embodiments, the threshold value THA can be set by an input through the manipulator unit 211. Thereby, it is possible to appropriately change the threshold value THA in accordance with the conditions of the substrate processing and the like.
(e) According to the present embodiments,
(f) According to the present embodiments, when the signal indicating that the accumulated film thickness A0 is equal to or greater than the threshold value THA is received from the monitor 220, the CLN time is calculated. Therefore, the CLN time is calculated only when CLN is performed. As a result, it is possible to reduce the calculation time of the CLN.
(g) According to the present embodiments, as the notification information, the display 212 displays the message indicating that the time to perform the CLN has arrived and that the CLN process will be executed. Therefore, it is possible to visually indicate information related to the CLN to the user.
(h) According to the present embodiments, before the CLN process is performed, when there is the wafer 7 placed on the boat 21, the unloading process of unloading the wafer 7 is performed. Such an unloading process is performed while the temperature of the process chamber 101 is being switched or while the CLN process is being performed on another boat 21. Therefore, the unloading time can be absorbed within other processes.
(i) According to the present embodiments, when the CLN process is started, a part of the CLN process such as the loading step of loading the boat 21 whose film thickness A is zero into the process chamber 101 is skipped. Therefore, it is possible to shorten an overall CLN process time.

When the plurality of boats 21 are used for one process vessel, the thickness of the accumulated film in each of the boats 21 may differ. Even in such case, it is possible to perform the cleaning to efficiently remove the accumulated film.

The technique of the present disclosure is described in detail by way of the embodiments mentioned above. However, the technique of the present disclosure is not limited thereto. The technique of the present disclosure may be modified in various ways without departing from the scope thereof.

For example, the embodiments mentioned above are described by way of an example in which the substrate to be processed is the semiconductor wafer substrate. However, the technique of the present disclosure is not limited thereto. For example, the technique of the present disclosure may be preferably applied to a substrate processing apparatus capable of processing a glass substrate such as an LCD (Liquid Crystal Display) device.

For example, the embodiments mentioned above are described by way of an example in which a silicon-based film is formed by the substrate processing performed by the substrate processing apparatus 1. However, the technique of the present disclosure is not limited thereto. That is, the technique of the present disclosure may be applied to a process such as a process of forming an oxide film or a nitride film and a process of forming a film containing a metal. For example, specific contents of the substrate processing are not limited to those exemplified in the embodiments mentioned above. For example, in addition to or instead of the film forming process mentioned above, the technique of the present disclosure may be applied to a process such as an annealing process, an oxidation process, a nitridation process, a diffusion process and a lithography process. In addition, the technique of the present disclosure may also be applied to other substrate processing apparatuses such as an annealing processing apparatus, an oxidation processing apparatus, a nitridation processing apparatus, an exposure apparatus, a coating apparatus, a drying apparatus, a heating apparatus and a CVD apparatus using plasma. Even in such a modified example, it is possible to obtain substantially the same effects as in the embodiments mentioned above.

For example, the embodiments mentioned above are described by way of an example in which a batch type substrate processing apparatus capable of simultaneously processing a plurality of substrates is used to form the film. However, the technique of the present disclosure is not limited thereto. For example, the technique of the present disclosure may be preferably applied when a single wafer type substrate processing apparatus capable of processing one or several substrates at a time is used to form the film. In addition, for example, the embodiments mentioned above are described by way of an example in which a substrate processing apparatus including a hot wall type process furnace is used to form the film. However, the technique of the present disclosure is not limited thereto. For example, the technique of the present disclosure may be preferably applied when a substrate processing apparatus including a cold wall type process furnace is used to form the film.

The process procedures and the process conditions of each process using the substrate processing apparatuses exemplified above may be substantially the same as those of the embodiments or modified examples described above. Even in such a case, it is possible to obtain substantially the same effects as in the embodiments or the modified examples described above.

The embodiments or the modified examples mentioned above may be appropriately combined. The process procedures and the process conditions of each combination thereof may be substantially the same as those of the embodiments or the modified examples mentioned above.

The entire contents of Japanese Patent Application No. 2022-194510, filed on December 5, 2022, are hereby incorporated in the present specification by reference. All documents, patent applications, and technical standards described in the present specification are hereby incorporated in the present specification by reference to the same extent that the contents of each of the documents, the patent applications and the technical standards are specifically described.

### [Description of Reference Numerals]

1 substrate processing apparatus, 21 substrate support, 103 process vessel, 200 controller, 207 memory

## Claims

1. A substrate processing apparatus comprising:
a substrate support configured to be capable of supporting at least one substrate;
a process vessel into which a plurality of substrate supports are individually loaded so the substrate supported by the substrate support is processed therein;
a memory configured to store accumulated film thickness values of the process vessel and the plurality of substrate supports; and
a controller configured to be capable of controlling an execution of a cleaning process for the process vessel and the substrate support by performing:
allocating a predefined cleaning time for the process vessel to the plurality of substrate supports based on the accumulated film thickness values of the plurality of substrate supports when the accumulated film thickness value of the process vessel is equal to or greater than a threshold value which is predefined, and
loading and unloading each of the plurality of substrate supports into and out of the process vessel in accordance with a cleaning time allocated for each of the plurality of substrate supports.

2. The substrate processing apparatus of claim 1, wherein the cleaning time for each of the plurality of substrate supports is proportional to the accumulated film thickness value of each of the plurality of substrate supports.

3. The substrate processing apparatus of claim 1, further comprising
a monitor configured to monitor the accumulated film thickness value of the process vessel,
wherein the monitor is further configured to transmit a cleaning signal to the controller when the accumulated film thickness value is equal to or greater than the threshold value.

4. The substrate processing apparatus of claim 3, further comprising
a manipulator configured to be capable of setting the threshold value of the process vessel,
wherein the monitor is further configured to compare the threshold value set by the manipulator with the accumulated film thickness value of the process vessel.

5. The substrate processing apparatus of claim 3, wherein the monitor is further configured to determine whether the accumulated film thickness value of the process vessel is equal to or greater than the threshold value when a substrate processing is completed.

6. The substrate processing apparatus of claim 1, further comprising
a calculator configured to calculate the cleaning time for each of the plurality of substrate supports,
wherein the controller is further configured to request the calculator to calculate the cleaning time for each of the plurality of substrate supports when the controller determines to start the cleaning process.

7. The substrate processing apparatus of claim 6, wherein the calculator is further configured to calculate the cleaning time for each of the plurality of substrate supports based on the predefined cleaning time for the process vessel and the accumulated film thickness values of the plurality of substrate supports.

8. The substrate processing apparatus of claim 6, wherein the controller is further configured to perform an execution control of the cleaning process based on a calculation result of the calculator.

9. The substrate processing apparatus of claim 1, wherein the controller is further configured to be capable of notifying the accumulated film thickness value of the process vessel as notification information when the accumulated film thickness value of the process vessel exceeds the threshold value.

10. The substrate processing apparatus of claim 9, wherein the memory is further configured to be capable of storing the notification information.

11. The substrate processing apparatus of claim 9, further comprising
a display capable of displaying the notification information,
wherein the display displays the notification information when the notification information is notified.

12. The substrate processing apparatus of claim 1, wherein the controller is further configured to unload the substrate from the substrate support before loading the substrate support into the process vessel in a case where the substrate is supported by the substrate support when the cleaning process is to be performed.

13. The substrate processing apparatus of claim 1, wherein the memory is further configured to clear the accumulated film thickness values stored in the memory after the cleaning process is completed.

14. The substrate processing apparatus of claim 13, wherein, when the cleaning process is preformed on the process vessel and the substrate support, the accumulated film thickness values of the process vessel and the accumulated film thickness value of the substrate support are cleared.

15. The substrate processing apparatus of claim 1, wherein the controller is further configured to, when the accumulated film thickness value of a substrate support has not been changed after being cleared, skip the cleaning process for the substrate support.

16. A method of manufacturing a semiconductor device, comprising
a substrate supporting step of supporting a substrate on a substrate support configured to be capable of supporting the substrate;
a substrate processing step of individually loading a plurality of substrate supports into a process vessel in which a substrate processing is performed to process a substrates;
a memory step of storing an accumulated film thickness value of the process vessel;
a memory step of storing accumulated film thickness values of the plurality of substrate supports; and
a cleaning step of performing a cleaning process for the process vessel and the substrate support by performing:
allocating a predefined cleaning time for the process vessel to the plurality of substrate supports based on the accumulated film thickness values of the plurality of substrate supports when the accumulated film thickness value of the process vessel is equal to or greater than a threshold value which is predefined, and
loading and unloading each of the plurality of substrate supports into and out of the process vessel in accordance with a cleaning time allocated for each of the plurality of substrate supports.

17. A program that causes a substrate processing apparatus, by a computer, to perform:
a substrate supporting step of supporting a substrate on a substrate support configured to be capable of supporting the substrate;
a substrate processing step of individually loading a plurality of substrate supports into a process vessel in which a substrate processing is performed to process a substrates;
a memory step of storing an accumulated film thickness value of the process vessel;
a memory step of storing accumulated film thickness values of the plurality of substrate supports; and
a cleaning step of performing a cleaning process for the process vessel and the substrate support by performing:
allocating a predefined cleaning time for the process vessel to the plurality of substrate supports based on the accumulated film thickness values of the plurality of substrate supports when the accumulated film thickness value of the process vessel is equal to or greater than a threshold value which is predefined, and
loading and unloading each of the plurality of substrate supports into and out of the process vessel in accordance with a cleaning time allocated for each of the plurality of substrate supports.
